Europäisches Patentamt

European Patent Office

Office européen des brevets

(11) Numéro de publication: **0 622 635 A1**

## (12) DEMANDE DE BREVET EUROPEEN

(21) Numéro de dépôt: **94106635.9**

(51) Int. Cl.5: **G01R 15/02**

(22) Date de dépôt: **28.04.94**

(30) Priorité: **30.04.93 FR 9305333**

(43) Date de publication de la demande:
**02.11.94 Bulletin 94/44**

(84) Etats contractants désignés:
**AT BE CH DE DK ES FR GB GR IT LI LU NL SE**

(71) Demandeur: **ZELLWEGER SAUTER-Energie S.A.**
**30, rue Marc Seguin**
**F-68200 Mulhouse (FR)**

(72) Inventeur: **Bach, Guy**
**11, rue du Pont d'Aspach**
**F-68520 Schweighouse (FR)**

(74) Mandataire: **Ellenberger, Maurice**
**Zellweger Luwa AG**
**Wilstrasse 11**
**CH-8610 Uster (CH)**

(54) **Capteur de courant pour courants alternatifs.**

(57) La présente invention concerne un capteur de courant pour la mesure isolée de courants alternatifs. L'invention doit permettre de réduire le coût des capteurs actuels et de s'affranchir des contraintes géométriques et constructives.

Ce capteur comporte un circuit primaire parcouru par la totalité du courant à mesurer et un circuit secondaire couplé au circuit primaire via un transformateur d'isolation compensé à plusieurs spires. Le circuit primaire est constitué d'un shunt (SH) de faible valeur ohmique et de bonne stabilité thermique parcouru par plus de 99 % du courant à mesurer Im et connecté, d'une part, à l'enroulement primaire (P1) du transformateur d'isolation compensé et, d'autre part, à une résistance réelle localisée (R1) en série avec l'enroulement primaire (P1), de bonne stabilité thermique mais de valeur ohmique élevée en regard de celle du shunt (SH). Les enroulements secondaires du transformateur d'isolation compensé sont connectés à une électronique associée (E). L'enroulement secondaire (S1) est connecté en parallèle à la résistance (R2), l'ensemble étant relié, d'une part, à la masse et, d'autre part, à la résistance (R3) dont l'autre patte est connectée à la sortie Vs, les résistances (R2) et (R3) présentant toutes deux une bonne stabilité thermique.

Figure 2b

La présente invention concerne un capteur de courant utilisé dans un wattheuremètre électronique polyphasé pour la mesure isolée de courants alternatifs selon la revendication 1.

## ETAT DE LA TECHNIQUE

Jusqu'à présent, le circuit primaire de tous les capteurs de courant alternatif isolés utilisant un transformateur compensé est toujours composé :

♦ soit d'un diviseur de courant passif dont la branche parcourue par le courant le plus faible forme également le primaire d'un transformateur, primaire ayant toujours une seule spire, par exemple le brevet US-A-4 182 982,

♦ soit d'un primaire de transformateur ayant au moins une spire et parcouru par la totalité du courant à mesurer, par exemple le brevet CH-A-573 121.

Le capteur de courant décrit dans le brevet CH-A-573 121 n'est composé dans son circuit primaire que d'un enroulement primaire de transformateur, de sorte que la totalité du courant à mesurer passe dans cet enroulement primaire. En conséquence, le noyau du transformateur doit être relativement important, ce qui a une incidence sur les coûts.

Le capteur de courant décrit dans le brevet US-A-4 182 982 est composé d'une plaque qui sert de diviseur de courant et de bobinage primaire de transformateur. La précision de ce dispositif est limitée par la géométrie de la plaque ainsi que la taille et la position de la fenêtre.

Le capteur de courant décrit dans le brevet EP-A-0 365 216 présente lui-aussi l'inconvénient de contrainte constructive puisque les éléments du diviseur de courant doivent être strictement coaxiaux.

## EXPQSE DU PRQBLEME

Dans le cas de la mesure des courants forts (environ 100 A), l'encombrement et le prix du transformateur imposent l'utilisation d'un circuit primaire avec diviseur de courant. L'effet Joule n'étant pas négligeable, une mesure précise du courant demande un diviseur de courant compact, réalisé avec des matériaux à faibles coefficients thermiques, afin de garantir un rapport de division indépendant de la température. Ce dernier point conduit toujours à la réalisation d'un capteur compact ce qui améliore l'homogénéité de la température.

Se pose alors le problème de l'intégration de plusieurs capteurs du même type dans un volume donné (par exemple, trois capteurs de courant dans un compteur d'énergie électrique triphasé) :

♦ soit les capteurs sont destinés à être montés sur un circuit imprimé; dans ce cas il faut employer des câbles de forte section pour y conduire le courant à mesurer,

♦ soit ils sont directement montés sur les liaisons électriques de puissance; il faut alors assurer une liaison électrique vers le circuit imprimé avec des fils isolés,

♦ chaque capteur et ses connexions de puissance devant être isolés du point de vue électrique et magnétique du reste du montage, on arrive toujours à un volume total très important.

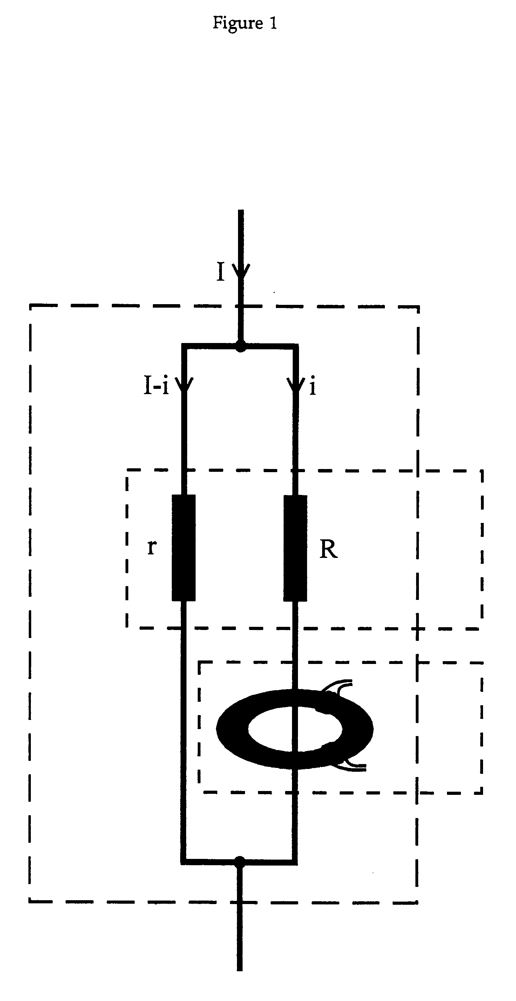

Le schéma décrivant le circuit primaire selon l'état de la technique est donné en figure 1. Ce type de circuit est un ensemble compact. Les "résistances" (r) et (R) sont réalisées dans le même matériau (par découpage par exemple). Elles sont définies par la répartition de résistivité du matériau ; il ne s'agit pas à proprement parler de composants réels :

♦ leurs valeurs ohmiques absolues ont peu d'importance (elles définissent les pertes par effet Joule lors du passage de courants forts) mais leurs valeurs relatives définissent le rapport de division du courant,

♦ elles ont le droit de dériver avec la température mais leurs valeurs ohmiques relatives devant rester constantes, on cherchera toujours à avoir un montage aussi compact que possible (pour le diviseur de courant) afin qu'elles soient à la même température,

♦ elles sont généralement obtenues à partir d'un même matériau dont les dérives thermiques sont faibles,

♦ à partir du moment où le courant se divise en deux et jusqu'à ce qu'il soit à nouveau réuni, il faut éviter toute rupture d'homogénéité dans la matière constituant le diviseur de courant (soudure, vissage, écrasement, pliage, etc.) sans quoi le rapport de division risquerait de changer avec la température et les contraintes mécaniques appliquées.

L'origine de toutes ces contraintes est la faible valeur des résistances constituant le diviseur de courant par comparaison avec les résistances parasites dues aux liaisons électriques reliant celles-ci. Il n'est pas possible d'augmenter les valeurs de (r) et de (R) car les pertes par effet Joule en feraient de même.

L'invention doit donc permettre de réduire le coût de ce capteur en utilisant un transformateur plus petit et de s'affranchir des contraintes géométriques et constructives grâce à l'utilisation d'éléments distincts, afin d'avoir une entière liberté dans la disposition des composants et la conception électronique de la carte sur laquelle ce nouveau capteur sera implanté. Nous proposons donc un nouveau type de circuit primaire.

## LISTE DES FIGURES

La figure 1 montre le circuit primaire selon l'état de la technique

La figure 2a montre le circuit primaire selon l'invention

La figure 2b montre la compensation de l'impédance parasite

La figure 3 montre un exemple de schéma fonctionnel du capteur selon l'invention.

## EXPOSE DE L'INVENTION

### Préambule : Rappel du fonctionnement d'un transformateur compensé

Un transformateur compensé :
♦ assure l'isolation galvanique,
♦ comporte au moins trois enroulements,
♦ est toujours associé à un circuit électronique.

Chaque enroulement a une fonction bien définie; il est impossible de les permuter. Ces enroulements sont :
♦ le bobinage de compensation
♦ le bobinage de détection
♦ le bobinage primaire

Toute variation du courant circulant dans le bobinage primaire entraîne une variation du flux magnétique total dans le noyau du transformateur. Cette variation de flux induit une tension dans le bobinage de détection qui est connecté à l'entrée d'un circuit électronique dont la sortie est connectée au bobinage de compensation. La fonction de ce circuit électronique est de contrôler le courant circulant dans le bobinage de compensation, afin de modifier le flux magnétique total pour annuler la tension apparue sur le bobinage de détection. La variation du courant circulant dans le bobinage de compensation, appelé courant de compensation, dépend de la variation du courant circulant dans le bobinage primaire. La sensibilité du circuit électronique n'étant pas infinie, la circulation d'un courant continu ou de fréquence très basse dans le bobinage primaire ne sera pas compensée par le bobinage de compensation. Les courants non compensés (le courant continu par exemple) peuvent perturber de manière plus ou moins importante le fonctionnement de l'ensemble car ils modifient la perméabilité magnétique, donc les inductances des différents bobinages, du matériau magnétique employé pour la réalisation du noyau du transformateur.

Si on se place dans la plage de fonctionnement d'un tel ensemble, on peut donc dire que la tension aux bornes du bobinage primaire reste toujours nulle et écrire :

$$N_{Primaire} \times I_{Primaire} = N_{Compensation} \times I_{Compensation}$$

N correspondant au nombre de spires et I étant le courant circulant dans le bobinage, l'indice représentant ledit bobinage.

### Exposé du nouveau circuit primaire

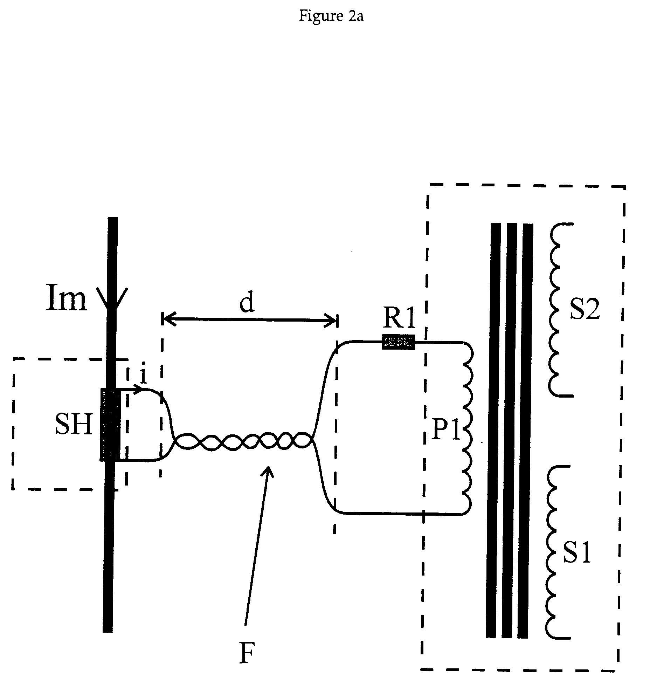

Le schéma du nouveau circuit primaire est donné en figure 2a.

Il comporte un shunt (SH), de faible valeur ohmique, réalisé en un matériau ayant une bonne stabilité thermique (en constantan par exemple, ou en manganin), une résistance réelle (R1) ayant également une bonne stabilité thermique et l'enroulement primaire (P1) d'un transformateur d'isolation compensé (TR), cet enroulement ayant plusieurs spires. Vu la très faible valeur ohmique du shunt (SH) en regard de celle de l'impédance d'entrée de tout le reste du circuit, la quasi-totalité du courant à mesurer Im, plus de 99,99 % avec les valeurs données en exemple, traverse le shunt dont la dissipation thermique reste tout de même faible.

Cet arrangement permet de dissocier le circuit de puissance (le shunt) du reste du montage qui n'est donc plus soumis à la dissipation thermique du shunt. La liaison électrique entre le shunt et le reste du montage peut alors se faire à l'aide de deux fils de petite section (F), l'impédance d'entrée étant très grande devant leur résistance.

Il est donc possible d'optimiser le placement, de choisir les matériaux et composants les plus adaptés et d'augmenter la précision tout en diminuant les coûts.

Vu la faible valeur ohmique du shunt (SH) on peut admettre que celui-ci, lors du passage du courant à mesurer Im, se comporte comme une source de tension parfaite dont la tension de sortie vaut SH x Im.

Si le circuit électronique associé au transformateur compensé est alimenté et utilisé dans sa plage nominale de fonctionnement, la tension présente aux bornes de (P1) reste toujours nulle. Dans ce cas, le courant circulant dans (P1) et (R1) correspond à $I_{P1} = Im \times (SH / R1)$

Le courant de compensation $I_{S1}$ vaut alors Im x $(SH / R1) \times (N_{P1} / N_{S1})$, S1 représentant le bobinage de compensation.

Toutefois, utilisé tel quel, ce nouveau circuit primaire présente quelques particularités qui sont :
♦ Le nombre important de spires nécessaires pour réaliser le bobinage primaire entraîne une augmentation de sa résistance ohmique et de son inductance de fuite.
♦ Toute variation de cette impédance parasite (résistance ohmique en série avec l'inductance de fuite) fausse la mesure.

♦ Le coefficient de température du cuivre étant important, il faut éviter son emploi si l'on veut faire des mesures précises.

Pour corriger ces particularités, il faut compenser cette impédance parasite.

## Compensation de l'impédance parasite

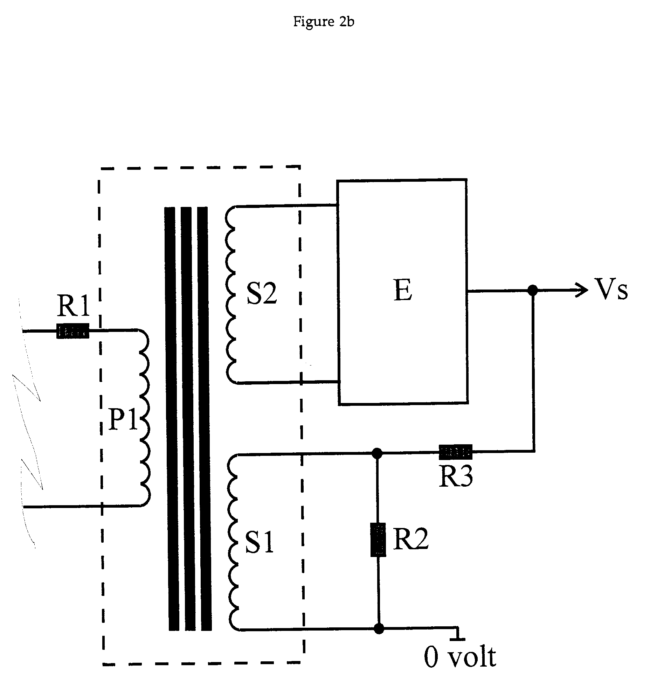

La figure 2b montre un schéma de réalisation.

La manière la plus simple, la plus efficace et la plus économique pour compenser cette impédance parasite consiste à :
- ♦ réaliser le bobinage de compensation (S1) de manière aussi identique que possible au bobinage primaire (P1), en terme de nombre de spires, diamètre et type du fil, diamètre et largeur de la gorge, symétrie du positionnement de (P1) et (S1) par rapport au noyau magnétique,
- ♦ monter deux résistances (R2) et (R3) du même type que (R1), (R2) étant connecté en parallèle à l'enroulement secondaire (S1), l'ensemble étant relié d'une part à la masse et d'autre part à la résistance (R3) dont l'autre patte est reliée à la sortie Vs
- ♦ calculer les valeurs de (R2) et (R3) en sachant que :

$$R1 = (R2 \times R3) / (R2 + R3)$$
$$Vs = (R3 / R1) \times SH \times Im$$

On obtient alors les résultats suivants :
- ♦ La compensation de l'impédance parasite est excellente car les effets dus à la dérive des caractéristiques du transformateur ne sont plus observables.
- ♦ Le transformateur peut maintenant être réalisé avec du fil de cuivre très fin, ce qui diminue encore sa taille.

## DESCRIPTION DE LA MANIERE DE REALISER L'INVENTION

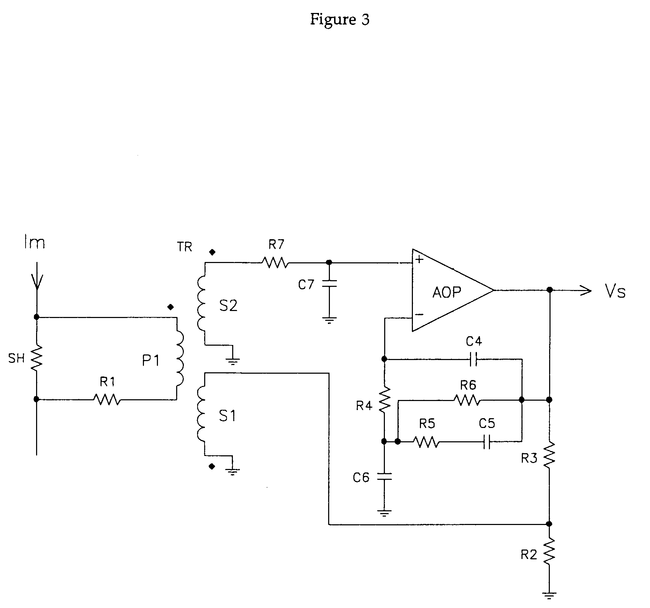

La figure 3 représente un exemple de schéma fonctionnel du capteur selon l'invention. Les valeurs de composants ci-après sont données à titre d'exemple.

Le circuit primaire de ce capteur de courant est parcouru par le courant à mesurer Im. Il est constitué d'un shunt (SH), de faible valeur ohmique (300 $\mu\Omega$) et de bonne stabilité thermique, connecté, d'une part, à l'enroulement primaire (P1) d'un transformateur d'isolation compensé et, d'autre part, à une résistance réelle localisée (R1) (15,5 $\Omega$) en série avec l'enroulement primaire (P1), de bonne stabilité thermique mais de valeur ohmique élevée en regard de celle du shunt (SH). Le grand rapport (> 50 000) entre la résistance (R1) et le shunt (SH) fait que la quasi totalité (plus de 99 %) du courant à mesurer Im traverse le shunt qui est donc le seul élément de puissance susceptible de chauffer lorsque le courant Im est très fort.

L'isolation entre le circuit primaire et le reste du montage est assuré par le transformateur d'isolation compensé dont l'enroulement secondaire (S2) est connecté à un circuit électronique associé (E) assurant le fonctionnement en mode compensé. L'enroulement secondaire (S1) dudit transformateur est connecté en parallèle à la résistance (R2) (17,8 $\Omega$), l'ensemble étant relié, d'une part, à la masse et, d'autre part, à la résistance (R3) (121 $\Omega$) dont l'autre patte est connectée à la sortie Vs, les résistances (R2) et (R3) présentant toutes deux une bonne stabilité thermique. Leur emploi se justifie par la nécessité de compenser l'impédance parasite de l'enroulement primaire (P1) au travers de l'enroulement secondaire (S1). Les résistances (R2) et (R3) permettent également d'ajuster le rapport Vs / Im. L'impédance parasite étant compensée, le transformateur d'isolation peut donc être réalisé avec du fil fin et bon marché, tel le cuivre. Les deux enroulements (P1) et (S1) sont indentiques (inductance de 76 mH).

Le circuit électronique associé (E) est composé :
- d'un amplificateur opérationnel (AOP),
- du filtre passe bas (de fréquence de coupure 340 kHz) formé par la résistance (R7) (1 k$\Omega$) et le condensateur (C7) (470 pF) qui assure la protection de l'entrée non inverseuse de l'amplificateur opérationnel (AOP) en présence d'un signal non compensable (transitoire rapide, amplitude trop forte, parasite),
- du filtre passe bas (de fréquence de coupure 2,5 mHz) formé par la résistance (R6) (287 k$\Omega$) et le condensateur (C6) (220 $\mu$F) qui assure une contreréaction pour les signaux de très basse fréquence notamment le courant continu (offset de l'amplificateur opérationnel),
- de la cellule de compensation formée par la résistance (R5) (100 k$\Omega$) et du condensateur (C5) (470 nF) qui réduit au minimum la résonance à basse fréquence, environ 1 Hz,
- du filtre passe haut (de fréquence de coupure 1,6 MHz) formé par la résistance (R4) (1 k$\Omega$) et le condensateur (C4) (100 pF) qui donne à l'amplificateur opérationnel (AOP) un gain unitaire et défini pour les hautes fréquences.

Si la fréquence du courant Im est dans le domaine nominal de fonctionnement du capteur, la tension de sortie Vs est directement représentative en amplitude et en phase de la composante alternative du courant à mesurer.

## AVANTAGES APPORTES PAR L'INVENTION

La réunion des deux principes exposés, nouveau circuit primaire et compensation de l'impédance parasite, permet maintenant de réaliser des capteurs de courant alternatif isolés caractérisés par :

♦ une très grande précision :
- Les problèmes dus à l'élévation de température du circuit de puissance sont facilement maîtrisés car ils sont localisés au niveau du shunt.
- Les effets dus à la dérive des caractéristiques du transformateur ne sont plus observables.

♦ un coût très bas en raison de l'utilisation de composants standards ou bon marché :
- Un shunt de puissance pour mesurer le courant alternatif ne coûte pas cher et sa réalisation peut être très robuste.
- Le transformateur compensé reste toujours très petit quelle que soit l'intensité du courant à mesurer (avec les valeurs données en exemple, nous avons un cube de 13 mm de côté pour une valeur de courant à mesurer Im de 90 $A_{eff}$.
- Le transformateur peut être réalisé avec du fil de cuivre très fin, ce qui diminue encore sa taille.
- La résistance (R1) n'étant ni liée au shunt ni dépendante de sa température, il s'agira donc d'un composant électronique traditionnel ou CMS (Composant Monté en Surface).
- Le courant de compensation à fournir par le circuit électronique est devenu très faible (inférieur à 2,6 mA avec les valeurs données en exemple). La consommation est donc plus faible et l'électronique n'est pas surdimensionnée. Pour mémoire, les autres montages nécessitent typiquement 1/1000 soit 90 mA efficace ou 127 mA crête dans notre exemple.

♦ une facilité de montage et d'intégration dans un volume donné car il n'y a aucune contrainte constructive :
- Le circuit de puissance (le shunt) et le transformateur compensé avec son électronique sont dissociés.
- Le montage de plusieurs shunts dans un boîtier donné peut être optimisé car chaque shunt peut avoir une géométrie différente.
- Le shunt est relié au reste du montage à l'aide de deux fils torsadés de petite section.
- Le transformateur compensé et son électronique associée sont montés sur un circuit imprimé, l'emplacement du shunt étant quelconque.

## Revendications

1. Capteur de courant pour courants alternatifs du type comportant un circuit primaire parcouru par la totalité du courant à mesurer et un circuit secondaire couplé au circuit primaire via un transformateur d'isolation compensé, caractérisé en ce que le circuit primaire est constitué d'un shunt (SH) de faible valeur ohmique et de bonne stabilité thermique parcouru par plus de 99 % du courant à mesurer Im et connecté, d'une part, à l'enroulement primaire (P1) dudit transformateur d'isolation compensé et, d'autre part, à une résistance réelle localisée (R1) en série avec l'enroulement primaire (P1), de bonne stabilité thermique mais de valeur ohmique élevée en regard de celle du shunt (SH) et en ce que les enroulements secondaires dudit transformateur d'isolation compensé sont connectés à une électronique associée (E).

2. Capteur de courant selon la revendication 1, caractérisé en ce que l'enroulement secondaire (S1) est connecté en parallèle à la résistance (R2), l'ensemble étant relié, d'une part, à la masse et, d'autre part, à la résistance (R3) dont l'autre patte est connectée à la sortie Vs, les résistances (R2) et (R3) présentant toutes deux une bonne stabilité thermique.

3. Capteur de courant selon la revendication 1, caractérisé en ce que chaque bobinage du transformateur d'isolation compensé comporte plus de deux spires.

Figure 1

Figure 2a

Figure 2b

Figure 3

Office européen
des brevets

**RAPPORT DE RECHERCHE EUROPEENNE**

Numero de la demande

EP 94 10 6635

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| Y | EP-A-0 365 216 (GENERAL ELECTRIC)<br>* page 6, ligne 10 - page 7, ligne 7 *<br>* page 7, ligne 22 - ligne 42; figures 1,8A-8C * | 1 | G01R15/02 |
| Y | EP-A-0 499 589 (LIAISONS ELECTRONIQUES-MECHANIQUES LEM)<br>* abrégé *<br>* colonne 3, ligne 6 - ligne 24; figure 1 * | 1 | |
| A | US-A-4 182 982 (WOLF ET AL.)<br>* abrégé *<br>* colonne 9, ligne 1 - ligne 20; figures 1,4 * | 1 | |
| A | FR-A-2 172 323 (SIEMENS)<br>* page 2, ligne 6 - ligne 30; figure 1 * | 1 | |
| | | | **DOMAINES TECHNIQUES RECHERCHES (Int.Cl.5)**<br><br>G01R |

Le présent rapport a été établi pour toutes les revendications

| Lieu de la recherche | Date d'achèvement de la recherche | Examinateur |
|---|---|---|
| LA HAYE | 2 Août 1994 | Iwansson, K |

EPO FORM 1503 03.82 (P04C02)